# EUROPÄISCHE PATENTANMELDUNG

(11) **EP 1 282 221 A2**
(43) Veröffentlichungstag der Anmeldung: **05.02.2003**
(21) Anmeldenummer: 01130954.9
(22) Anmeldetag: 28.12.2001
(51) Int. Cl.: H02M 3/00

(54) **Spannungsversorgungsmodul**

(30) Priorität: 17.02.2001 DE 10107609
(71) Anmelder: Power-One AG, 8610 Uster (CH)
(72) Erfinder: Chapuis, Alain, 8610 Uster (CH); Gammenthaler, Peter, 8335 Hittnau (CH)
(74) Vertreter: Behrmann, Niels, Dipl.-Ing.

(57) **Zusammenfassung**

Die Erfindung betrifft ein Spannungsversorgungsmodul für hohe Ausgangsströme, insbesondere DC-DC-Wandler, mit einem zum Zusammenwirken mit einer Planarinduktivität ausgebildeten, eine Mehrzahl von Leitungsschichten aufweisenden plattenförmigen Trägerelement (10), welches zur Aufnahme eines Kernelements der Planarinduktivität einen geeignet ausgebildeten Durchbruch (12) aufweist, bestückungsseitig zur automatisierbaren Bestückung mit Elektronikkomponenten (16), insbesondere einem Leistungshalbleiter (14), ausgebildet ist und ausgangsseitig zum Abführen des hohen Ausgangsstroms eine Kontakteinrichtung (40)aufweist, wobei bestückungsseitig ein eine Leitung für den Ausgangsstrom ausbildendes, streifen- und/oder schienenförmiges Brückenelement (18) eines Leitungsquerschnitts > 2 mm² so vorgesehen ist, dass das Brückenelement als vom Trägerelement unabhängiges Bauteil mittels eines bevorzugt automatischen Bestükkungsverfahrens auf dem Trägerelement montier- und kontaktierbar ist.

## Beschreibung

Die vorliegende Erfindung betrifft ein Spannungsversorgungsmodul nach dem Oberbegriff des Patentanspruchs 1, und insbesondere einen DC-DC-Wandler vom Synchrontyp, wie er aus dem Stand der Technik allgemein bekannt ist.

Bei elektronischen Verbrauchern für ein solches Spannungsversorgungsmodul besteht die zunehmende Tendenz hin zu niedrigeren Versorgungsspannungen, insbesondere auch kleiner als 3,3 Volt (derzeit gängig sind z. B. DC-Versorgungsspannungen im Bereich zwischen 1,2 und 1,8 Volt), wobei gattungsbildende Spannungsversorgungsmodule solche Versorgungsspannungen aus Eingangsspannungen im Bereich zwischen 40 und 60 Volt stabil und mit niedrigem Rauschpegel erzeugen.

Dadurch, dass der Leistungsbedarf von Hochleistungsprozessoren immer größer wird, deren Versorgungsspannung aber gleichzeitig sinkt (um höhere Taktfrequenzen zu erreichen), steigen die notwendigen Betriebsströme überproportional an. Für Versorgungsspannungen von 1,2 bis 1,8 Volt liegen entsprechend die von gängigen Spannungsversorgungsmodulen zu erzeugenden Ausgangsströme im Bereich von 60 Ampère oder höher. Dies gilt insbesondere im Zusammenhang mit sog. DPAs (Distributed Power Architectures).

Aufgrund der dadurch gegebenen hohen Strom- bzw. Leistungsdichten war es daher bislang notwendig, eine Mehrzahl von DC-DC-Konvertern vorzusehen, um diesen anspruchsvollen Stromversorgungsaufgaben gerecht zu werden. Neben dem hierfür notwendigen herstellungs- bzw. schaltungstechnischen Aufwand bringt dies jedoch noch zusätzlich den Nachteil vergleichsweise großer, voluminöser Gehäuse für die Spannungsversorgungsmodule mit sich, so dass insbesondere in räumlich beengten Einsatzumgebungen Platzprobleme entstehen.

Aus dem Stand der Technik ist es dabei bekannt, eine eine Mehrzahl von Leitungsschichten aufweisende Leiterplatte (sog. Multilayer) zum Aufbau von DC-DC-Wandlern zu benutzen, wobei der Multilayer sowohl mit entsprechenden Leistungshalbleitern bestückt wird, als auch, durch entsprechende Durchbrüche, zur Aufnahme von Kernen für Planarinduktivitäten ausgebildet ist. Zum Kühlen sowohl der Induktivitäten, als auch der Leistungshalbleiter sorgt ein dem Multilayer als Trägerelement zugeordnetes Kühlelement, wobei auf diesem Wege eine vergleichsweise kompakte, thermisch und elektrisch günstige Anordnung entsteht. Eine derartige Vorrichtung ist z. B. aus der deutschen Patentanmeldung 197 40 283.6 der Anmelderin bekannt.

Allerdings ist auch eine solche bekannte Anordnung im Hinblick auf weiter steigende Strom- bzw. Leistungsdichten und eine beabsichtigte weitere Erhöhung der Packungsdichte (bei Verkleinerung der Gehäuseabmessungen) nachteilig, denn, bedingt durch das eingesetzte Multilayer-Printplattenmaterial, liegt selbst bei bis zu 12 verwendeten einzelnen Leiterschichten einer typischen Schichtdicke von 100 Mikrometern eine physikalisch realisierbare Grenze für einen maximal zu erzeugenden Ausgangsstrom bei etwa 60 Ampère. Eine weitere Erhöhung des Ausgangsstroms würde dagegen Leiterbahngeometrien notwendig machen, welche sich in üblichen Gehäusegrößen bzw. Leiterplattenabmessungen nicht mehr sinnvoll realisieren lassen.

Darüber hinaus ist zwar aus dem genannten gattungsbildenden Stand der Technik die Möglichkeit bekannt, ein (typischerweise aus Aluminium gefertigtes) Kühlelement gleichzeitig sowohl zum Kühlen eines Kerns einer Induktivität, als auch eines Leistungshalbleiters zu verwenden; insbesondere jedoch bei einer weiter ansteigenden Bestückungsbzw. Packungsdichte einer solchen Vorrichtung ist auch die aus der DE 197 40 283.6 bekannte Wärmeabfuhr nicht ausreichend.

Schließlich zeigt sich bei bekannten Konvertervorrichtungen das Problem, dass der hohe Ausgangsstrom auch zuverlässig abgeführt werden muss; bislang existierende Pin- bzw. Anschlussverbindungen sind jedoch, gerade im Hinblick auf eine einfache (bevorzugt automatisierte) Bestückung und Fertigung und angesichts der angestrebten Stromstärken, nicht ausreichend.

Über allen Ansätzen steht zudem die technologische Herausforderung, ein bekanntes Spannungsversorgungsmodul prozesstechnisch leichter fertigen zu können, wobei anzustreben ist, weitestgehend hier automatische Bestückungs- und Lötverfahren einsetzen zu können.

Aufgabe der vorliegenden Erfindung ist es daher, ein gattungsbildendes Spannungsversorgungsmodul sowohl im Hinblick auf eine weitere Erhöhung des erzeugbaren Ausgangsstroms (bei entsprechend niedrigen Ausgangsspannungen) zu verbessern, als auch die Wärmeabfuhr bzw. Kühlung der elektronischen Baugruppen zu verbessern (und somit die Voraussetzung für weitere Integration zu bilden), und schließlich insbesondere auch die Möglichkeiten für ein sicheres Abführen der hohen Stromstärken zu erweitern. Damit soll ein Spannungsversorgungsmodul geschaffen werden, welches sich zudem in verbesserter Weise für eine automatisierte Fertigung und mithin für eine Kostensenkung im Produktionsverfahren eignet.

Die Aufgabe wird durch das Spannungsversorgungsmodul nach den Patentansprüchen 1, 10 und 14 gelöst; vorteilhafte Weiterbildungen der Erfindung sind in den Unteransprüchen beschrieben. Dabei wird als zur Erfindung gehörig jegliche Kombination von Anspruchsmerkmalen beansprucht, und zwar auch unabhängig von einem tatsächlichen Rückbezug der vorliegenden Patentansprüche. Insbesondere sind daher auch Merkmalskombinationen von Unteransprüchen mit anderen als den unmittelbar zugeordneten unabhängigen Ansprüchen als von der Erfindung umfasst anzusehen.

In erfindungsgemäß vorteilhafter Weise ermöglicht es das gemäß einem ersten Aspekt der Erfindung vorgesehene Brükkenelement, in herstellungs- und funktionstechnisch eleganter Weise das Problem der hohen Stromdichte, insbesondere zwischen ausgangsseitiger Kontakteinrichtung und den Synchron-Leistungshalbleitern, zu lösen, wobei, insbesondere durch Vorgabe eines geeigneten Querschnitts des bevorzugt verwendeten Kupfermaterials, hier ohne größere Erwärmung die geforderten hohen Ausgangsströme verarbeitet werden können. Gleichzeitig ist fertigungstechnisch das Brükkenelement wie ein normales, automatisiert bestück- und lötbares Bauteil (etwa SMD-Elektronikbauelement) zu behandeln und zu verarbeiten, so dass zusätzlicher Montage- und Verbindungsaufwand erspart bleibt und die erfindungsgemäße Vorrichtung mit üblichen Bestückungs- und Löteinrichtungen automatisiert und damit die Gesamteinheit effizient gefertigt werden kann. Dabei ist die Querschnittsangabe von 1,5 mm² gemäß Hauptanspruch für eine untere Grenze lediglich exemplarisch zu verstehen, da, um überhaupt brauchbar zu sein, ein erfindungsgemäßes Brückenelement, gegenüber einer Kupfer-Leiterbahn (von typischerweise 150 Mikrometer Stärke) eine gewisse Verbessrung hinsichtlich der Verlustleistung ermöglichen muss, und dies bezogen auf eine für eine automatisierbare Bestückung geeignete Leitungslänge, die typischerweise ab 5 bis 10 mm liegen kann. Von der vorliegenden Erfindung sind aber insbesondere auch solche Leitungsquerschnitte für das erfindungsgemäße Brückenelement umfasst, die etwa aufgrund anderer Materialparameter, einen signifikanten (d. h. um mindestens einen Faktor 4 bis 5 höheren) Abfall der Verlustleistung ermöglichen.

Vorteilhaft wird dabei auch das typischerweise als Multilayer ausgebildete Trägerelement thermisch entlastet, so dass hier an die Eigenschaften des eingesetzten Materials weniger hohe Anforderungen gestellt werden müssen und ggf. weitere Ersparnisse möglich sind.

Während gemäß einer bevorzugten Ausführungsform der Erfindung das erfindungsgemäße Brückenelement SMD-montagefähig ist, also auf der Oberfläche befestigt wird, ist es gemäß einer Weiterbildung vorgesehen, am Brückenelement Positioniernocken im Form der Positionierabschnitte vorzusehen, die insbesondere ein leichteres und präziseres Platzieren des Elementes an die gewünschte Position auf der Bestükkungsseite des Trägerelements ermöglichen.

In der Art eines langgestreckten, abgewinkelten Streifens ist es besonders bevorzugt, das erfindungsgemäße Brükkenelement so auf der Bestückungsseite zu führen, dass der (ohnehin vorhandene) Platz zwischen weiteren Elektronikelementen bzw. induktiven Bauelementen auf dem Trägerelement ausgenutzt werden kann, wobei es diese Ausbildung insbesondere auch ermöglicht, das Brückenelement möglichst nahe an den entsprechenden Anschlussbeinen der Synchron-Leistungshalbleiter kontaktbildend vorbeizuführen und so Übergangswiderstände zu vermindern.

Der weiterbildungsgemäß vorgesehene, bestückungsseitig vorgesehene Ausschnitt im Brückenelement ermöglicht es zudem, wirksam jede Gefahr eines Kurzschlusses bzw. eines unbeabsichtigten Kontaktes mit einer oberflächenseitig vorgesehenen Leiterbahn auf dem Trägerelement zu vermeiden.

Im Ergebnis entsteht somit durch die vorliegende Erfindung in überaus flexibler, einfach zu montierender und betriebssicherer Weise eine Möglichkeit, das Dilemma permanent steigender Ausgangsströme bei der Notwendigkeit zunehmend kompakterer Geräte in ungewöhnlicher Weise dadurch zu lösen, dass die ausgangsseitige Hochstromleitung als (automatisiert bestück- und montierbares) Bauelement begriffen wird, statt einer Benutzung der im Multilayer vorhandenen, jedoch im effektiven Leitungsquerschnitt begrenzten Leiterbahnen. Dabei ermöglicht es die durch die Abwinkelungen nahezu beliebig formbare Streifenform des Brükkenelements, auf der Bestückungsseite des Trägerelements ohnehin vorhandene Lücken bzw. Freiflächen flexibel auszunutzen, so dass das angestrebte Ziel eines kompakteren Aufbaus bei geringerer Erwärmung (und dies trotz höherer Stromstärken) elegant erreicht werden kann.

Ein zweiter Aspekt der vorliegenden Erfindung, für den unabhängig, aber auch in Verbindung mit dem ersten Erfindungsaspekt Schutz beansprucht wird, sieht dabei vor, das Zusammenwirken zwischen dem Kühlelement und den Elektronikkomponenten auf der Bestückungsseite des Trägerelements zu verbessern. Erfindungsgemäß ist nämlich vorgesehen, durch geeignete Formgebung der betreffenden Oberflächenseite des Kühlelements mittels der erfindungsgemäß vorgesehenen Wannen eine Kontur des Kühlelements zu schaffen, welche in thermisch und elektrisch optimaler Weise der -- über die Gesamtoberfläche der Bestückungsseite variierenden -- Höhe der jeweils montierten Bauelemente folgt, entsprechend die Möglichkeit bietet, durch Einsatz eines wärmeleitenden Kontaktmediums eine einfache Wärmeabfuhr zum Kühlelement herzustellen, und zudem, bedingt durch die Wannenform, den Einsatzbereich bzw. die effektive Einsatzfläche für das Kontaktmedium (d. h. die Vergussmasse) begrenzt zu halten. Als "selektives Vergießen" im Rahmen der Erfindung ist daher solches Füllen der (konturmäßig schon nachgebildeten) schmalen Übergangsbereiche zwischen Kühlelement einerseits und Bauteil- bzw. Printoberfläche andererseits zu verstehen, welche sich nicht über die Gesamtfläche des Trägerelements bzw. des Kühlelements erstreckt, sondern vielmehr auf die tatsächlich relevanten Übergangsbereiche beschränkt ist. Dies macht sich insbesondere auch im Hinblick auf einen Verbrauch der (teueren) Silikon-basierten Vergussmasse od. dgl. aus. Ein weiterer vorteilhafter Effekt liegt darin, dass -- was praktisch ohnehin äußerst schwierig wäre -die Bauteile- bzw. Höhentoleranzen der montierten Bauelemente nicht beliebig eng gezogen werden müssen; vielmehr nimmt die Vergussmasse in dem betreffenden wannenförmigen Ausschnitt des Kühlelements diese Toleranzen elegant auf. Im Rahmen der vorliegenden Erfindung ist es auch vorgesehen, den ersten und zweiten Erfindungsaspekt zu kombinieren, so dass, wie an späterer Stelle mit den Ausführungsbeispielen zu erläutern sein wird, insbesondere auch etwa eine wannenförmige Vertiefung für ein Brückenelement vorgesehen ist.

Ein dritter Aspekt der vorliegenden Erfindung löst das gerade im Hinblick auf automatisierte Fertigung entstehende Problem eines für den hohen Ausgangsstrom geeigneten Kontaktelements, welches einerseits einfach und kontaktsicher mit einer entsprechenden Anschlusskomponente bzw. Printplatte eines nachgeschalteten Verbrauchers (i. a. einer großen Printplatte) zusammenwirken soll, und andererseits trotzdem automatisiert bestück- und lötbar sein soll, ohne dass es etwa beim Verlöten mit einem verbraucherseitigen Leiterplattenelement zu einem Entlöten der ursprünglichen Verbindung kommt.

In erfindungsgemäß vorteilhafter Weise wird dies einerseits dadurch gelöst, dass eine Verbindung zu einer verbraucherseitigen Leiterplatte über Finger des erfindungsgemäßen Steckerelements erreicht wird, während anderenends dieses durch den Flanschabschnitt automatisiert bestück- und lötbar ist.

Auf die beschriebene Weise entsteht somit eine überaus kompakte, leistungsstarke Anordnung, welche insbesondere den Anforderungen zukünftiger Verbraucher im Niedervoltbereich gerecht wird und ein Maximum an automatisierter Bestückund Fertigbarkeit mit optimierten thermischen bzw. Wärmeabfuhreigenschaften kombiniert. Auch hier gilt, dass dieser Erfindungsaspekt mit den vorbeschriebenen ersten bzw. zweiten Erfindungsaspekten (d. h. Brückenelement bzw. wannenförmige Vertiefungen und partielles Vergießen) kombiniert werden kann, so dass insoweit beliebige Kombinationen der nachfolgend anhand der Ausführungsbeispiele beschriebenen Merkmale bzw. der Unteransprüche möglich und von der Erfindung umfasst sind.

Weitere Vorteile, Merkmale und Einzelheiten der Erfindung ergeben sich aus der nachfolgenden Beschreibung bevorzugter Ausführungsbeispiele sowie anhand der Zeichnungen; diese zeigen in
- Fig. 1:: eine schematische Draufsicht auf die Bestückungsseite des Multilayer-Trägerelements gemäß einer ersten bevorzugten Ausführungsform der vorliegenden Erfindung, die insoweit dem best mode entspricht;
- Fig. 2:: eine Draufsicht auf das Brückenelement zur Verwendung als automatisch bestückbares Bauteil im Ausführungsbeispiel gemäß Fig. 1;
- Fig. 3:: eine Seitenansicht des Brückenelements gemäß Fig. 2;
- Fig. 4:: eine Draufsicht auf den Eingriffsbereich eines Kühlelements zum Zusammenwirken mit dem Multilayer-Trägerelement gemäß Fig. 1;
- Fig. 5:: eine Schnittansicht entlang der Schnittlinie V-V in Fig. 4;
- Fig. 6:: eine schematische Schnittansicht zum Verdeutlichen der ausgangsseitigen Kontakteinrichtung gemäß einer weiteren Ausführungsform der vorliegenden Erfindung und
- Fig. 7:: eine Detailansicht des einteiligen bzw. einstückigen Steckerelements zur Verwendung in der Anordnung gemäß Fig. 6.

Eine als Multilayer ausgebildete Leiterplatte 10 (Trägerelement) weist in ansonsten bekannter Weise Durchbrüche 12 auf, in welche magnetisch wirksame Kerne, zum Ausbilden von Planarinduktivitäten zusammen mit Leiterbahnabschnitten des Multilayers 10, einsetzbar sind.

Ferner ist die Leiterplatte 10 mit Elektronikbauelementen, etwa Leistungshalbleitern 14 und weiteren passiven Bauelementen 16 (lediglich schematisch angedeutet), bestückt, um einen Synchronwandlung (mit ansonsten bekannter Schaltungstopologie) zu realisieren. In ansonsten bekannter Weise sind die Bauelemente 14, 16 durch automatisierte Bestükkungs- und Lötverfahren, etwa SMD, montierbar.

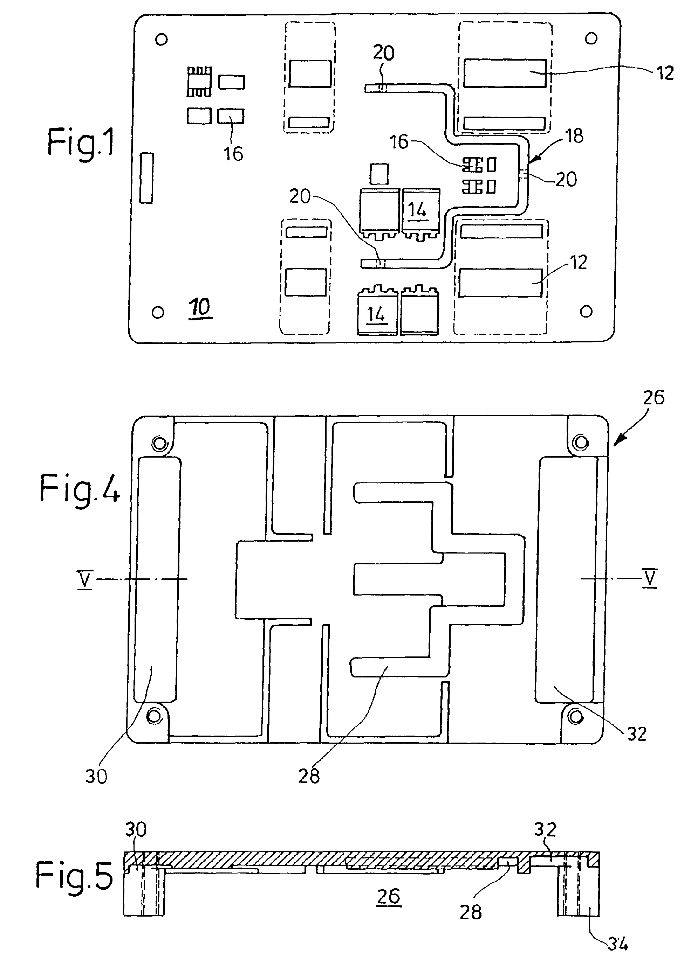

Die Fig. 1 zeigt zudem als mehrfach gewinkeltes bügelförmiges Element 18 ein elektrisch leitfähiges Brückenelement, welches, geeignet gebogen aus einem vernickelten und dann verzinnten Kupferstreifen, eine Leiterbahn von den Synchron-Leistungshalbleitern 14 bis hin zu einer (nicht gezeigten) ausgangsseitigen Kontakteinrichtung anbietet.

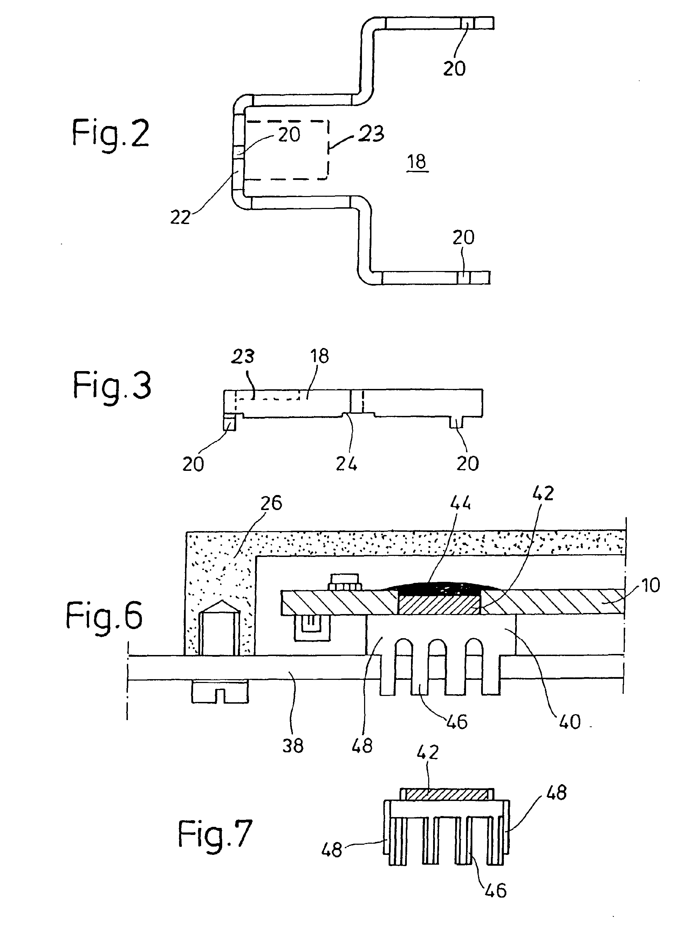

Genauer gesagt ist, wie insbesondere anhand der Fig. 2 und 3 gut zu erkennen ist, das Brückenelement 18 aus ca. 2 mm dickem und (bezogen auf die Bestückungsoberfläche der Leiterplatte 10) 4 mm hohen Material gebildet, so dass sich eine effektive, rechteckige Querschnittsfläche von ca. 8 mm² für eine ausgangsseitige Stromstärke von typischerweise 100 A ausbildet.

Zudem verdeutlicht die Seitenansicht der Fig. 3, dass bodenseitig (d.h. in Richtung auf die Leiterplatte 10) in einem mittleren Bereich 22 des Brückenelements sowie endseitig Positioniernocken 20 hervorstehen, welche an den in Fig. 1 schematisch gezeigten Positionen zum Zweck der besseren Positionierung in geeignet zugeordnete Vertiefungen in der Leiterplatte 10 eingreifen. Im gezeigten Ausführungsbeispiel dienen die Positioniernocken 20 jedoch nicht der eigentlichen Fixierung; diese erfolgt vielmehr in ansonsten bekannter Weise durch ein aus SMD-Fertigungsverfahren bekanntes Oberflächenlötverfahren.

Wie zudem die Fig. 1 verdeutlicht, ist das Brückenelement 18 mäander- bzw. bügelförmig so über die bestückungsseitige Oberfläche der Leiterplatte 10 geführt, dass bestehende Zwischenräume zwischen montierten Bauelementen günstig ausgenutzt werden können und so praktisch kein zusätzlicher Platzbedarf auf der Oberfläche entsteht.

Die Seitenansicht der Fig. 3 verdeutlicht zudem eine bodenseitige Ausnehmung 24, welche im Bestückungszustand sicherstellt, dass es zu keiner unerwünschten Kontaktbildung mit (in der Fig. 1 nicht gezeigten) Leiterbahnen auf der Oberfläche der Multilayer-Leiterplatte 10 kommen kann.

Eine weitere bevorzugte Weiterbildung der Erfindung ist in den Fig. 2 und 3 schematisch angedeutet und mit dem Bezugszeichen 23 bezeichnet. Ein bevorzugt einstückig am mittleren Bereich 22 des Brückenelements 18 ansitzender, eine plane Oberfläche ausbildender Flanschabschnitt 23 ist nämlich dazu vorgesehen, von einem (typischerweise pneumatischen) Bestückungsautomaten aufgenommen zu werden und erleichtert damit das automatische Positionieren bzw. Bestükken auch des Brückenelements 18. Dabei wirkt es sich für ein Angreifen durch den Bestückungsautomaten besonders günstig aus, wenn der Flanschabschnitt 23 eine plane obere Oberfläche ausbildet, welche im Montagezustand des Brükkenelements parallel zur Bestückungsoberfläche des Trägerelements 10 verläuft.

Die Fig. 4 und 5 verdeutlichen, wie, entsprechend dem Aufbau bzw. der Höhenkontur der bestückten Leiterplatte 10, ein zugeordnetes Kühlelement 26 aus geeignet geformtem (gefrästem oder gegossenem) Aluminium Vertiefungen in Form von Wannen aufweist, so dass der veränderlichen Oberflächenkontur der Bestückungsseite des Prints 10 weitgehend gefolgt werden kann. Dabei sind die wannenförmigen Ausnehmungen im Kühlelement 26, vgl. etwa eine den Verlauf des Brückenelements 18 nachgeformte Ausnehmung 28, oder linksbzw. rechtsseitige Wannen 30, 32 für in der Fig. 1 nicht gezeigte Elemente im Randbereich der Leiterplatte, so hinsichtlich einer effektiven Tiefe dimensioniert, dass auf (auch in automatisierten Fertigungsprozessen nicht vollständig vermeidbare) Abweichungen in der Bestückungshöhe durch Toleranzen flexibel reagiert werden kann, und zwar dadurch, dass die betreffenden Wannen bzw. Ausnehmungen selektiv mit einer Vergussmasse ausgefüllt werden und dementsprechend einen sicheren Wärmeübergang zum jeweils zu kühlenden Partner herstellen.

Dabei ist der Begriff "Wanne" nicht auf vollständig umschlossene Gebiete beschränkt; wie insbesondere der Draufsicht auf die Konturen gemäß Fig. 4 entnehmbar ist, zählen hierzu auch größtenteils bzw. teilweise umschlossene Flächengebiete, welche dann selektiv mit Vergussmasse für zugehörige Elektronikkomponenten versehen werden können. Wie zudem die Fig. 5 verdeutlicht, sind an den Ecken des Kühlelements 26 einstückig ansitzende Abstandshalter 34 für eine Montage mit anderen Baugruppen bzw. der Leiterplatte 10 vorgesehen.

Unter Bezug auf die Fig. 6 und 7 soll im weiteren ein Ausführungsbeispiel beschrieben werden, welches, in produktionstechnisch besonders günstiger Weise, eine Möglichkeit zur Ableitung des hohen Ausgangsstroms zu einer Leiterplatte 38 eines zugeordneten Verbrauchers verdeutlicht.

Genauer gesagt ist zu diesem Zweck in der Leiterplatte 10 durch Reflow-Löten ein (in Fig. 7 im Detail gezeigtes) kamm- bzw. gabelförmiges Steckerelement 40 verankert, welches an seinem der Leiterplatte 10 zugeordneten Ende einen zum Zusammenwirken mit einem entsprechenden Langloch vorgesehenen, für das automatische Lötverfahren vorgesehenen Flanschabschnitt 42 aufweist, welcher zudem eine leicht geriffelte und damit einen guten Halt im Print sicherstellende Außenfläche aufweist (das Bezugszeichen 44 verdeutlicht das automatisiert aufgebrachte Lot).

Am entgegengesetzten Ende besitzt das Steckerelement 40 vier Finger 46, welche in geeignete Durchbrüche des Verbraucher-Prints 38 eingreifen und auch dort durch geeignete, bevorzugt automatisierte Lötverfahren befestigt werden können. Alternativ kann das Steckerelement auch beidseits Finger bzw. gabelförmige Vorsprünge besitzen, und entsprechend würde in der Leiterplatte 10 anstelle des Langlochs eine Mehrzahl von entsprechenden (Rund-) Löchern für eine Mehrzahl von Fingern vorgesehen sein.

Besonders bevorzugt ist das Steckerelement 40 ein aus Kupferblech od.dgl. gefertigtes und dann vernickeltes bzw. verzinntes Stanzteil, wobei, zumindest endseitig, die Finger 46 vorteilhaft in eine runde oder annähernd runde Form gebracht werden, um in entsprechende Bohrungen des Verbraucher-Prints 38 eingreifen zu können. Zu erkennen ist zudem, wie endseitige Vorsprünge bzw. Verdickungen an den Fingern 46 einen wirksamen Anschlag bzw. ein Widerlager für die Verbraucher-Leiterplatte 38 anbieten.

Die gezeigte Anordnung besitzt, neben ihrer vorteilhaften Leitfähigkeit für den hohen Ausgangsstrom, den Vorteil, einerseits in der Leiterplatte 10 durch automatisierte Bestückungs- und Lötverfahren einfach und ökonomisch befestigbar zu sein. Andererseits sorgt jedoch die erfindungsgemäße Gabel- bzw. Kammform dafür, dass nachfolgende Lötprozesse an den Fingerenden 46 (anders als bei einem durchgängig streifenförmigen Kontaktelement) nicht etwa zu einem möglichen Lösen der Lötstelle 44 führen, sondern vielmehr diese ohne Beeinflussung der Kontaktgüte unbeeinflusst lassen.

Im Ergebnis lässt sich auch durch diese Maßnahme daher das Ziel einer kompakten, automatisiert und ökonomisch fertigbaren, gleichwohl für höchste Stromstärken geeigneten Konvertereinheit realisieren, so dass durch die vorliegende Erfindung in bislang unbekannter Weise Möglichkeiten zur weiteren Volumenverringerung von erfindungsgegenständlichen Spannungsversorgungsmodulen gegeben werden.

Während die vorliegende Erfindung primär am Beispiel eines DC-DC-Wandlers beschrieben wurde, sind die Erfindungsaspekte nicht auf eine solche Anordnung beschränkt. Vielmehr eignet sich die vorliegende Erfindung für beliebige Spannungsversorgungsmodule, die für hohe ausgangs- oder eingangsseitige Ströme einen zuverlässigen und einfach fertigbaren Lösungsweg suchen.

## Patentansprüche

1. Spannungsversorgungsmodul für hohe Ausgangsströme, insbesondere DC-DC-Wandler, mit
einem zum Zusammenwirken mit einer Planarinduktivität ausgebildeten, eine Mehrzahl von Leitungsschichten aufweisenden plattenförmigen Trägerelement (10), welches zur Aufnahme eines Kernelements der Planarinduktivität einen geeignet ausgebildeten Durchbruch (12) aufweist,
bestückungsseitig zur automatisierbaren Bestückung mit Elektronikkomponenten (16), insbesondere einem Leistungshalbleiter (14), ausgebildet ist und
ausgangsseitig zum Abführen des hohen Ausgangsstroms eine Kontakteinrichtung (40)aufweist,
**dadurch gekennzeichnet, dass**
bestückungsseitig ein eine Leitung für den Ausgangsstrom ausbildendes, streifen- und/oder schienenförmiges Brückenelement (18) eines Leitungsquerschnitts > 1,5 mm², bevorzugt > 2 mm², so vorgesehen ist, dass das Brückenelement als vom Trägerelement unabhängiges Bauteil mittels eines bevorzugt automatischen Bestückungsverfahrens auf dem Trägerelement montier- und kontaktierbar ist.

2. Spannungsversorungsmodul nach Anspruch 1, **dadurch gekennzeichnet, dass** das Brückenelement aus bevorzugt vernickeltem und/oder verzinktem Kupfermaterial hergestellt ist und einen i. w. rechteckigen, weiter bevorzugt sich senkrecht zur Bestückungsseite erstrekkenden Leitungsquerschnitt aufweist.

3. Spannungsversorgungsmodul nach Anspruch 1 oder 2, **dadurch gekennzeichnet, dass** das Brückenelement auf einer dem Trägerelement zugewandten Seite mindestens einen nockenförmig vorspringenden Positionierabschnitt (20) aufweist, der zum Zusammenwirken mit einer entsprechend in einer bestückungsseitigen Oberfläche des Trägerelements gebildeten Ausnehmung ausgebildet ist.

4. Spannungsversorgungsmodul nach einem der Ansprüche 1 bis 3, **dadurch gekennzeichnet, dass** das Brückenelement einen in einem Montagezustand auf dem Trägerelement parallel zum Trägerelement verlaufenden Flächenund/oder Flanschabschnitt (23) aufweist, welcher zum Zusammenwirken mit und/oder zum Zugriff durch einen Bestückungsautomaten für das automatische Bestükkungsverfahren bemessen und ausgebildet ist.

5. Spannungsversorgungsmodul nach einem der Ansprüche 1 bis 4, **dadurch gekennzeichnet, dass** das Spannungsversorgungsmodul ein Synchrongleichrichter ist und das Brückenelement zum Verbinden eines Synchron-Leistungshalbleiters (14) mit einem Steckerelement als Kontaktiereinrichtung ausgebildet ist.

6. Spannungsversorgungsmodul nach einem der Ansprüche 1 bis 5, **dadurch gekennzeichnet, dass** das Brückenelement für einen Ausgangsstrom > 60 Ampère, bevorzugt > 80 Ampère, ausgebildet ist und einen Leitungsquerschnitt > 4 mm² aufweist.

7. Spannungsversorgungsmodul nach einem der Ansprüche 1 bis 6, **dadurch gekennzeichnet, dass** das Brückenelement in einer durch das Trägerelement bestimmten Ebene abgewinkelt ist.

8. Spannungsversorgungsmodul nach Anspruch 7, **dadurch gekennzeichnet, dass** das Brückenelement eine Mehrzahl von i. w. rechtwinkligen Abwinkelungen aufweist.

9. Spannungsversorgungsmodul nach einem der Ansprüche 1 bis 8, **dadurch gekennzeichnet, dass** das Brückenelement kontaktseitig einen Ausschnitt (24) aufweist, der so ausgebildet ist, dass in einem Montagezustand des Brückenelements dieses einen im Bereich des Ausschnitts verlaufenden Leiterbahnabschnitt einer obenliegenden Leitungsschicht des Trägerelements nicht kontaktiert.

10. Spannungsversorgungsmodul für hohe Ausgangsströme, insbesondere DC-DC-Wandler, mit
einem zum Zusammenwirken mit einer Planarinduktivität ausgebildeten, eine Mehrzahl von Leitungsschichten aufweisenden plattenförmigen Trägerelement (10), welches zur Aufnahme eines Kernelements der Planarinduktivität einen geeignet ausgebildeten Durchbruch (12) aufweist, bestückungsseitig zur automatisierbaren Bestückung mit Elektronikkomponenten (16), insbesondere einem Leistungshalbleiter (14), ausgebildet ist und
ausgangsseitig zum Abführen des hohen Ausgangsstroms eine Kontakteinrichtung (40) aufweist,
und wobei das Trägerelement zum Zusammenwirken mit einem plattenförmigen Kühlelement (26) so ausgebildet ist, dass das Kühlelement eine Kühlung des Kernelements der Planarinduktivität sowie einer bestückungsseitig vorgesehenen Elektronikkomponente realisiert,
**dadurch gekennzeichnet, dass**
das Kühlelement auf seiner in einem Montagezustand dem Trägerelement zugewandten Seite mindestens eine bevorzugt einstückig in das Kühlelementmaterial eingearbeitete bzw. geformte wannenförmige Vertiefung (28, 30, 32) aufweist, die einer bestückungsseitigen Oberflächenkontur des mit Elektronikkomponenten bestückten Trägerelements nachgeformt ist und ein selektives Vergießen im Bereich der wannnenförmigen Vertiefung mit einer wärmeleitenden Vergussmasse ermöglicht.

11. Spannungsversorgungsmodul nach Anspruch 10, **dadurch gekennzeichnet, dass** das Kühlelement aus einem Aluminiummaterial realisiert ist und/oder an einer dem Trägerelement abgewandten Flachseite eine Gehäuseaußenwand des Spannungsversorgungsmoduls ausbildet.

12. Spannungsversorgungsmodul nach Anspruch 10 oder 11,
**dadurch gekennzeichnet, dass** die wärmeleitende Vergussmasse eine Silikon-basierte Vergussmasse ist.

13. Spannungsversorgungsmodul nach einem der Ansprüche 10 bis 12, **dadurch gekennzeichnet, dass** bestückungsseitig ein eine Leitung für den Ausgangsstrom ausbildendes,streifen-und/oderschienenförmigesBrückenelement (18) eines Leitungsquerschnitts > 1,5 mm², bevorzugt > 2 mm², so vorgesehen ist, dass das Brükkenelement als vom Trägerelement unabhängiges Bauteil mittels eines bevorzugt automatischen Bestückungsverfahrens auf dem Trägerelement montier- und kontaktierbar ist.

14. Spannungsversorgungsmodul für hohe Ausgangsströme, insbesondere DC-DC-Wandler, mit
einem zum Zusammenwirken mit einer Planarinduktivität ausgebildeten, eine Mehrzahl von Leitungsschichten aufweisenden plattenförmigen Trägerelement (10), welches zur Aufnahme eines Kernelements der Planarinduktivität einen geeignet ausgebildeten Durchbruch (12) aufweist, bestückungsseitig zur automatisierbaren Bestückung mit Elektronikkomponenten (16), insbesondere einem Leistungshalbleiter (14), ausgebildet ist und
ausgangsseitig zum Abführen des hohen Ausgangsstroms eine Kontakteinrichtung (40) aufweist,
**dadurch gekennzeichnet, dass**
die Kontakteinrichtung ein einstückig gebildetes, gabelförmiges Steckerelement (40) aufweist, welches einends eine Mehrzahl von durch einen Brückenabschnitt (48) verbundenen Fingerabschnitten (46) für ein Zusammenwirken mit einer nachgeschalteten Verbrauchereinheit und anderenends einen am Brückenabschnitt ansitzenden Flanschabschnitt (42) aufweist, der zum automatisierten Verlöten des Steckerelements auf das Trägerelement, insbesondere mittels eines Reflow-Lötverfahrens, ausgebildet ist.

15. Spannungsversorgungsmodul nach Anspruch 14, **dadurch gekennzeichnet, dass** die Fingerabschnitte einen rechteckigen Leitungsquerschnitt aufweisen, welcher endseitig in eine runde oder Vieleck-Form geformt ist.

16. Spannungsversorgungsmodul nach Anspruch 14 oder 15,
**dadurch gekennzeichnet, dass** mindestens ein endseitiger der Fingerabschnitte eine einen Anschlag für ein zu kontaktierendes Leiterplattenelement ausbildende Verdickung aufweist.

17. Spannungsversorgungsmodul nach einem der Ansprüche 14 bis 16, **dadurch gekennzeichnet, dass** bestückungsseitig ein eine Leitung für den Ausgangsstrom ausbildendes, streifen- und/oder schienenförmiges Brückenelement (18) eines Leitungsquerschnitts > 1,5 mm², bevorzugt > 2 mm², so vorgesehen ist, dass das Brükkenelement als vom Trägerelement unabhängiges Bauteil mittels eines bevorzugt automatischen Bestückungsverfahrens auf dem Trägerelement montier- und kontaktierbar ist.

18. Spannungsversorgungsmodul nach einem der Ansprüche 14 bis 17, **dadurch gekennzeichnet, dass** das Trägerelement zum Zusammenwirken mit einem plattenförmigen Kühlelement (26) so ausgebildet ist, dass das Kühlelement eine Kühlung des Kernelements der Planarinduktivität sowie einer bestückungsseitig vorgesehenen Elektronikkomponente realisiert, und das Kühlelement auf seiner in einem Montagezustand dem Trägerelement zugewandten Seite mindestens eine bevorzugt einstükkig in das Kühlelementmaterial eingearbeitete bzw. geformte wannenförmige Vertiefung (28, 30, 32) aufweist, die einer bestückungsseitigen Oberflächenkontur des mit Elektronikkomponenten bestückten Trägerelements nachgeformt ist und ein selektives Vergießen im Bereich der wannnenförmigen Vertiefung mit einer wärmeleitenden Vergussmasse ermöglicht.
